# EUROPÄISCHE PATENTANMELDUNG

(11) **EP 2 882 260 A1**
(43) Veröffentlichungstag der Anmeldung: **10.06.2015**
(21) Anmeldenummer: 13195560.1
(22) Anmeldetag: 03.12.2013
(51) Int. Cl.: H05B 33/08, G01R 31/26, B60Q 11/00

(54) **Überwachungsschutzschaltung für Beleuchtungsanlagen**

(71) Anmelder: Contronix GmbH, 01445 Radebeul (DE)
(72) Erfinder: Gommel, Christoph, 01159 Dresden (DE)
(74) Vertreter: Lippert, Stachow & Partner

(57) **Zusammenfassung**

Die Erfindung betrifft eine Überwachungsschutzschaltung für Beleuchtungsanlagen, welche eine Beleuchtungseinheit, eine Energieversorgung und eine elektrische Größen messende Messeinrichtung umfasst, sowie ein Verfahren, welches die Überwachungsschutzschaltung nutzt. Die Aufgabe, eine Überwachungsschutzschaltung zur Verfügung zu stellen, die geeignet ist, Fehlerwiderstände in der Beleuchtungsanlage zu erkennen, wird dadurch gelöst, dass eine Überwachungsschutzschaltung, welche einen die Beleuchtungseinheit ein- und ausschaltenden Lastschalter und ein strom- und / oder spannungsbegrenzendes Bauteil umfasst, so genutzt wird, dass bei Übereinstimmung der ermittelten Spannung U_{L} über der Beleuchtungseinheit mit der erwarteten Spannung U_{Soll} oder des ermittelten Stroms I_{L} durch den Messpfad mit dem erwarteten Strom Iₛₒₗₗ aus der Soll-Strom-Spannungskennlinie der Beleuchtungseinheit die Beleuchtungseinheit eingeschaltet und bei einer festzulegenden Abweichung der Spannung U_{L} über der Beleuchtungseinheit von der erwarteten Spannung U_{Soll} oder des Stromes I_{L} von dem erwarteten Strom I_{Soll} aus der Soll-Strom-Spannungskennlinie der Beleuchtungseinheit die Beleuchtungseinheit unverzüglich ausgeschaltet wird.

## Beschreibung

Die Erfindung betrifft eine Überwachungsschutzschaltung für Beleuchtungsanlagen, welche eine Beleuchtungseinheit, eine Energieversorgung und eine elektrische Größen messende Messeinrichtung umfasst.

Unter einer Beleuchtungsanlage ist in erster Linie eine Anlage zu verstehen, welche wenigstens eine Energieversorgung und eine Beleuchtungseinheit umfasst, wobei die Beleuchtungseinheit von der Energieversorgung mit Energie versorgt wird.

In der Beleuchtungstechnik werden immer mehr herkömmliche Leuchtmittel, wie beispielsweise Glühlampen, durch Leuchtdioden (kurz LEDs von engl. light-Emitting Diodes) ausgetauscht, vor allem wegen der hohen Energieeffizienz, der langen Lebensdauer und den technischen Fortschritten, was deren Leuchtstärke und spektrale Charakteristik betrifft.

LEDs werden in sehr vielen verschiedenen Bereichen eingesetzt. Beispielsweise in der Automobilindustrie für die Lichterzeugung in Bremsleuchten, Blinkern, wie auch Hauptscheinwerfern oder Heckleuchten von Fahrzeugen.

Weitere Einsatzgebiete stellen LED Taschenlampen wegen des geringen Stromverbrauches der LEDs, Flutlichtstrahler mit LED-Arrays, Treppenbeleuchtungen mit LED-Streifen, Signalanzeigen, Kontrollanzeigen sowie Lichterketten und Lichtvorhänge mit sparsamen LEDs dar, um nur einige Beispiele zu nennen. Es können auch OLEDs (Organic-Light-Emitting-Diodes) zum Einsatz kommen.

In der Beleuchtungstechnik werden je nach Beleuchtungsaufgabe unterschiedliche LEDs eingesetzt, u.a. werden Hochleistungs-LEDs oder aber eine Vielzahl von kleineren bzw. schwächeren LEDs verwendet. Da die LEDs zumeist nur mit bestimmten Ausgangsleistungen und für bestimmte Ströme verfügbar sind, werden insbesondere bei kleinen und schwachen LEDs LED-Anordnungen mit einem oder mehreren LED-Arrays vorgesehen. Derartige LED-Anordnungen mit einem oder mehreren LED-Arrays werden beispielsweise in Flächenleuchten verwendet. Vor allem für die Dekoration in der Werbeindustrie, in beleuchteten Schriftzügen und Reklameschriften ist die LED nicht mehr wegzudenken.

Obwohl LEDs eine extrem hohe Lebensdauer besitzen, so dass ein turnusmäßiger Austausch oder eine regelmäßige Wartung, wie es bei anderen Leuchtmitteln notwendig ist, nicht mehr erforderlich ist, ergibt sich doch das Erfordernis, die seltenen Totalausfälle oder allmählichen Degradationen einzelner LED-Anordnungen zu erfassen, um rechtzeitig Gegenmaßnahmen treffen zu können. In der DE 10 2009 017 989 A1 ist beispielsweise eine Überwachungseinrichtung offenbart, die an die Leitung, über die die LED-Anordnung von einem Vorschaltgerät mit Betriebsleistung versorgt wird, angeschlossen ist. Die Überwachungseinrichtung überwacht eine an der Leitung erfassbare elektrische Größe, z.B. die Spannung an dem LED-Modul. Durch Überwachung des Spannungsverlaufes und insbesondere plötzliche Spannungsänderungen kann ein LED-Fehler erfasst und bei Bedarf signalisiert werden.

Aber nicht nur Fehler im Betrieb der einzelnen LEDs oder der LED-Module können zu einem Betriebsausfall von Teilen oder der gesamten Beleuchtungsanlage führen. Auch Kurzschlüsse oder generell auftretende Fehlerwiderstände, z.B. durch Feuchtigkeit, Alterung oder Zerstörung können bei hohen Strömen zu einer unkontrollierbaren Wärmeentwicklung führen, die in ungünstigen Fällen zu einem Brand führen und somit nicht nur die Anlage, sondern auch die Umgebung gefährden.

Auch wenn zur Energieversorgung der Beleuchtungsanlage ein Netzteil mit Überlasterkennung genutzt wird, die auf einer Strom-Spannungsmessung im Betriebsfall basiert, würde beispielsweise ein sehr kleiner Widerstand nicht oder kaum erkannt werden, so dass es zu einer gefährlichen Wärmeentwicklung bis hin zum Brand und der Zerstörung der Anlage kommen kann.

Es stellt sich somit die Aufgabe, eine Überwachungsschutzschaltung zur Verfügung zu stellen, die geeignet ist, sowohl kleine als auch große Fehlerwiderstände in der Beleuchtungsanlage zu erkennen, welche im ungünstigsten Fall zu großen thermischen Lasten bis hin zu Bränden und der Zerstörung der Anlage führen können.

Die Aufgabe wird anordnungsseitig mit der vorgeschlagenen Überwachungsschutzschaltung dadurch gelöst, dass ein mit der Beleuchtungseinheit verbundener Lastpfad und ein Messpfad ausgebildet sind, wobei in dem Lastpfad, ein die Beleuchtungseinheit ein- und ausschaltender Lastschalter angeordnet ist und in dem Messpfad eine die Spannung über dem Lastschalter und / oder den Strom im Messpfad messende Messeinrichtung angeordnet ist, wobei die Messeinrichtung ein Bauteil umfasst, welches parallel zum Lastschalter angeordnet und als ein strombegrenzendes und / oder spannungsbegrenzendes Bauteil ausgebildet ist, und dieser Teil des Messpfades mit einer die gemessene Spannung und / oder den gemessenen Strom auswertenden Einheit verbunden ist, die einen Steuerausgang aufweist, der mit dem Lastschalter diesen steuernd verbunden ist.

In einer Ausgestaltung der vorgeschlagenen Überwachungsschutzschaltung umfasst die Beleuchtungseinheit mindestens eine Leuchtdiode. Beispielsweise können für beleuchtete Werbeschriftzüge mehrere LEDs in Reihe sowie parallel zueinander geschaltet angeordnet sein.

In einer anderen Ausgestaltung der vorgeschlagenen Überwachungsschutzschaltung ist in Reihe zu dem Bauteil im Messpfad ein zweiter, alternativ zum Lastschalter schaltender Schalter angeordnet. Der Vorteil ist, dass damit nicht nur die Beleuchtungseinheit von der Energieversorgung getrennt wird, sondern die Beleuchtungsanlage vollständig von der Energieversorgung getrennt werden kann.

In einer Ausgestaltung der vorgeschlagenen Überwachungsschutzschaltung ist das Bauteil im Messpfad derart ausgebildet, dass ein resultierender Prüfstrom Iₓ mindestens eine bis fünf Größenordnungen kleiner als der Nennstrom im Arbeitspunkt der Beleuchtungseinheit ist. Das Bauteil im Messpfad ist in einer Ausgestaltung der vorgeschlagenen Überwachungsschutzschaltung ein Widerstand. Sollte im Fehlerfall ein geringer Fehlerwiderstand auftreten, so lassen sich damit auch bei einem geringen Spannungsabfall über dem Spannungsteiler kleine Stromflüsse detektieren.

In einer weiteren Ausgestaltung der vorgeschlagenen Überwachungsschutzschaltung ist das Bauteil im Messpfad derart ausgebildet, dass eine resultierende Prüfspannung Uₓ kleiner als die Flussspannung der Beleuchtungseinheit ist. Das Bauteil im Messpfad ist in einer Ausgestaltung der vorgeschlagenen Überwachungsschutzschaltung eine Zenerdiode.

Die Schalter zum Ein- und Ausschalten der Beleuchtungseinheit oder der Beleuchtungsanlage können elektronisch arbeitend ausgebildet sein. Beispielsweise können Transistoren zum Einsatz kommen.

Zur Vermeidung bzw. Verringerung von EMV-Problemen aufgrund von hohen Stromtransienten werden die Schaltzeiten des Lastschalters um wenige Mikrosekunden (1 bis 10 µs) verlängert. Dies erfolgt in vorteilhafter Weise über ein RC-Glied.

Die Schalter können aber auch elektromagnetisch arbeitend ausgebildet sein, beispielsweise können Relais zum Einsatz kommen.

Die für die Auswertung der gemessenen Signale auswertende Einheit kann vorzugsweise als ein Mikrocontroller mit integriertem oder separatem Analog-Digital-Wandler ausgebildet sein. Vorteilhaft ist dabei, dass dieser auch andere Kontroll- und Steueraufgaben in der Beleuchtungsanlage ausführen kann.

In einer weiteren Ausgestaltung ist die vorgeschlagene Überwachungsschutzschaltung mit diskreter Logik oder in einem ASIC (Anwendungsspezifische Integrierte Schaltung) ausgebildet.

Die Aufgabe wird verfahrensseitig mit dem vorgeschlagenen Verfahren gelöst, wobei die vorgeschlagene Überwachungsschutzschaltung genutzt wird, welche einen die Beleuchtungseinheit ein- und ausschaltenden Lastschalter und ein strombegrenzendes und / oder spannungsbegrenzendes Bauteil im Messpfad umfasst und in dem Verfahren folgende Schritte ausgeführt werden:
- die Energieversorgung der Beleuchtungseinheit wird über den Lastschalter unterbrochen,
- mit der Messeinrichtung wird über einen aus Beleuchtungseinheit und dem Bauteil im Messpfad gebildeten Spannungsteiler die Spannung U_{L} über der Beleuchtungseinheit ermittelt, oder mit der Messeinrichtung wird mit dem spannungsbegrenzenden Bauteil im Messpfad der Strom I_{L} durch die Beleuchtungseinheit ermittelt,
- die ermittelte Spannung U_{L} oder der ermittelte Strom I_{L} wird mit einer bekannten Soll-Strom-Spannungskennlinie der Beleuchtungseinheit verglichen, wobei
- bei Übereinstimmung der ermittelten Spannung U_{L} mit der erwarteten Spannung U_{Soll} aus der Soll-Strom-Spannungskennlinie der Beleuchtungseinheit die Beleuchtungseinheit eingeschaltet und bei einer festzulegenden Abweichung der Spannung U_{L} von der erwarteten Spannung U_{Soll} aus der Soll-Strom-Spannungskennlinie der Beleuchtungseinheit die Beleuchtungseinheit unverzüglich ausgeschaltet wird, oder bei Übereinstimmung des ermittelten Stroms I_{L} mit dem erwarteten Strom I_{Soll} aus der Soll-Strom-Spannungskennlinie der Beleuchtungseinheit die Beleuchtungseinheit eingeschaltet und bei einer festzulegenden Abweichung des Stroms I_{L} von dem erwarteten Strom Iₛₒₗₗ aus der Soll-Strom-Spannungskennlinie der Beleuchtungseinheit die Beleuchtungseinheit unverzüglich ausgeschaltet wird.

Der Vorteil dieses Verfahrens ist, dass Fehlerwiderstände, die eventuell zu einer brandauslösenden Wärmeentwicklung führen können noch vor der Inbetriebnahme der Beleuchtungseinheit erkannt werden und die Beleuchtungseinheit gar nicht erst eingeschaltet wird.

Dabei wird die Nichtlinearität der Strom-Spannungskennlinie von Leuchtdioden auf vorteilhafte Weise genutzt. Bis zum Erreichen der Flussspannung ist der Stromfluss durch die LEDs nahezu Null und die LEDs werden erst bei einer von der Art der LED abhängigen bestimmten Flussspannung leitend. Wird ein Spannungsabfall in der Größenordnung der von der Art der LED abhängigen Flussspannung gemessen, so bedeutet das, dass die Last ausschließlich aus den die Beleuchtungseinheit bildenden LEDs besteht. Liegt die gemessene Spannung unterhalb der Flussspannung, so erkennt die Steuereinheit dies und verweigert das Einschalten des Lastschalters, da damit ein Fehlerzustand vorliegen muss.

Die Nichtlinearität der Strom-Spannungskennlinie von Leuchtdioden wird auch in einer zweiten vorteilhaften Weise genutzt. Wird die Spannung, welche über der Beleuchtungseinheit abfallen kann, auf unterhalb der Flussspannung der Dioden-Anordnung begrenzt und liegt der gemessene Strom durch den Messpfad und die Beleuchtungseinheit in der Größenordnung, welche nach der Art der LED-Anordnung aus deren Strom-Spannungskennlinie zu erwarten ist, so bedeutet das, dass die Last ausschließlich aus den die Beleuchtungseinheit bildenden LEDs besteht. Weicht der gemessene Strom um einen festzulegenden Wert, der nach der Strom-Spannungskennlinie der LED-Anordnung zu erwarten ist, ab, so erkennt die Steuereinheit dies und verweigert das Einschalten des Lastschalters, da damit ein Fehlerzustand vorliegen muss.

Das vorgeschlagene Verfahren kann sowohl im Einschaltvorgang der Beleuchtungseinheit als auch während des Betriebs der Beleuchtungsanlage durchgeführt werden. Damit lässt sich die Beleuchtungseinheit sowie die Beleuchtungsanlage sofort abschalten, sobald während des Betriebes der Anlage ein Fehlerzustand eintritt. Der Vorteil ist, dass damit ein Fehlerzustand zeitnah erkannt und diesem rechtzeitig begegnet werden kann. Damit kann sowohl die Beleuchtungseinheit als auch die komplette Beleuchtungsanlage sowie der Einsatzort der Beleuchtungsanlage vor Folgen eines Fehlerzustandes, z.B. eines Brandes, geschützt werden, wobei erhebliche Kosten gespart werden können.

Deshalb werden die Schritte des Verfahrens zeitlich periodisch wiederholt. Die Messintervalle können dabei so schnell ausgeführt werden (< 1 Millisekunde), dass keine wahrnehmbare Verdunklung der Beleuchtung auftritt. Durch die periodische Überwachung der Anlage und die schnelle Reaktion auf Fehlerzustände ist es nicht mehr möglich, einen plötzlich auftretenden Fehlerwiderstand nennenswert zu erwärmen. Beispielsweise ist mit den eingesetzten Komponenten der Überwachungsschutzschaltung die Spannung über dem Spannungsteiler sehr schnell messbar, z.B. besitzen Transistoren sehr schnelle Schaltzeiten, so dass ein periodisches Öffnen des Lastschalters im Lastpfad für wenige Mikrosekunden (µs) zu einer kaum wahrnehmbaren Verdunklung der Anlage führt.

Die Messung des Nennstroms und der Nennspannung über der Beleuchtungseinheit kann auch in der Dunkelphase einer pulsweitenmodulierten Dimmung erfolgen. Dabei ist darauf zu achten, dass die Taktfrequenz der Ein- und Ausschaltdauer ausreichend hoch gewählt wird (beispielsweise 300 Hz), so dass das Auge, auch bei schneller Bewegung, keine Helligkeitsschwankungen (Flimmern) wahrnehmen kann.

Mit einem zweiten alternativ zum Lastschalter schaltenden Schalter kann die Beleuchtungseinheit bei einer festzulegenden Abweichung der Spannung U_{L} von der erwarteten Spannung U_{Soll} aus der Soll-Strom-Spannungskennlinie der Beleuchtungseinheit oder bei einer festzulegenden Abweichung des Stromes I_{L} von dem erwarteten Strom I_{Soll} aus der Soll-Strom-Spannungskennlinie der Beleuchtungseinheit vollständig von der Energieversorgung getrennt werden. Die Soll-Strom-Spannungskennlinie der Beleuchtungseinheit stellt dabei den Zusammenhang zwischen Strom und Spannung über der Beleuchtungseinheit im Betriebsfall der Beleuchtungsanlage dar.

Die Erfindung soll nachfolgend anhand von Ausführungsbeispielen näher erläutert werden.

In den zugehörigen Zeichnungen zeigen die
- Fig. 1a: die charakteristische Strom-Spannungskennlinie einer Leuchtdiode,
- Fig. 1b: die Strom-Spannungskennlinie einer Leuchtdiode mit Fehlerwiderstand,
- Fig. 2a: die schematische Darstellung der Überwachungsschutzschaltung im Testbetrieb, wobei ein strombegrenzendes Bauteil im Messpfad ausgebildet und der Schalter S1 am Fußpunkt der Überwachungsschutzschaltung angeordnet ist,
- Fig. 2b: die schematische Darstellung der Überwachungsschutzschaltung im Testbetrieb, wobei ein spannungsbegrenzendes Bauteil im Messpfad ausgebildet und der Schalter S1 am Fußpunkt der Überwachungsschutzschaltung angeordnet ist,
- Fig. 3a: die schematische Darstellung der Überwachungsschutzschaltung im Testbetrieb, wobei ein strombegrenzendes Bauteil im Messpfad ausgebildet und der Schalter S1 an der Energieversorgung angeordnet ist,
- Fig. 3b: die schematische Darstellung der Überwachungsschutzschaltung im Testbetrieb, wobei ein spannungsbegrenzendes Bauteil im Messpfad ausgebildet und der Schalter S1 an der Energieversorgung angeordnet ist,
- Fig. 4a: die schematische Darstellung der Überwachungsschutzschaltung im Testbetrieb in Verbindung mit einer möglichen Anwendungsschaltung, wobei eine symmetrische Strommessung und eine Steuereinheit mit integriertem A/D-Wandler verwendet wird,
- Fig. 4b: die schematische Darstellung der Überwachungsschutzschaltung im Testbetrieb in Verbindung mit einer möglichen Anwendungsschaltung, wobei eine symmetrische Strommessung und eine Steuereinheit mit externem A/D-Wandler verwendet wird,
- Fig. 5a: die schematische Darstellung der Überwachungsschutzschaltung im Testbetrieb in Verbindung mit einer möglichen Anwendungsschaltung, wobei eine unipolare Strommessung und eine Steuereinheit mit integriertem A/D-Wandler verwendet wird,
- Fig. 5b: die schematische Darstellung der Überwachungsschutzschaltung im Testbetrieb in Verbindung mit einer möglichen Anwendungsschaltung, wobei eine unipolare Strommessung und eine Steuereinheit mit externem A/D-Wandler verwendet wird.

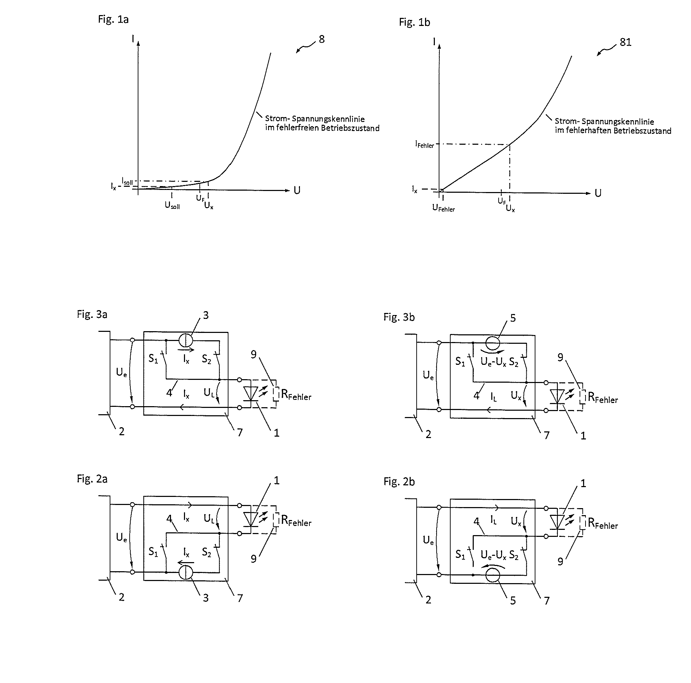

Fig. 1a zeigt die charakteristische Strom-Spannungskennlinie einer Leuchtdiode, wobei der abrupte Übergang vom nichtleitenden in den leitenden Zustand der Diode für die Auswertung von Fehlerzuständen in der Beleuchtungsanlage genutzt wird, was nachfolgend näher erläutert wird. U_{F} bezeichnet die Flussspannung, ab der die Dioden-Anordnung leitet.

Fig. 1b zeigt die Strom-Spannungskennlinie einer Leuchtdiode mit einem Fehlerwiderstand, der in der Beleuchtungsanlage auftritt. Der ohmsche Anteil eines Fehlerwiderstandes wird in der veränderten Strom-Spannungskennlinie deutlich.

Fig. 2a zeigt die schematische Darstellung der vorgeschlagenen Überwachungsschutzschaltung 7 im Testbetrieb, wobei ein strombegrenzendes Bauteil 5 im Messpfad 3 ausgebildet ist und der Schalter S1 am Fußpunkt der Überwachungsschutzschaltung 7 angeordnet ist. Als Testbetrieb wird der Zustand bezeichnet, in welchem die Beleuchtungsanlage auf mögliche Fehlerzustände bzw. Fehlerwiderstände in der Beleuchtungsanlage untersucht wird. In Bezug auf die Kennlinie einer Diode (Fig. 1) wird der Strom durch ein Bauteil 5, z.B. einen Widerstand, auf einen bestimmten festgelegten Wert Iₓ (Prüfstrom) begrenzt. Anschließend wird über den Spannungsteiler, welcher aus der Beleuchtungseinheit 1 und dem Widerstand 5 gebildet wird, die Spannung U_{L} über der Beleuchtungseinheit 1 ermittelt. Dieser Wert wird mit einem Wert U_{Soll} aus der Soll-Strom-Spannungskennlinie der Beleuchtungseinheit 1 im Betriebsfall verglichen (veranschaulicht als Strich-Punkt-Linie in Fig.la und Fig.lb). Tritt eine festzulegende Abweichung zwischen U_{L} und U_{Soll} auf, z.B. wenn ein Fehlerwiderstand R_{Fehler} in der Beleuchtungsanlage vorhanden ist (veranschaulicht als Strich-Punkt-Linie in Fig. 1b), so wird die Beleuchtungseinheit 1 unverzüglich ausgeschaltet. Anderenfalls wird die Beleuchtungseinheit 1 eingeschaltet bzw. bleibt weiter in Betrieb (veranschaulicht als Strich-Punkt-Linie in Fig.1a).

Fig. 2b zeigt die schematische Darstellung der vorgeschlagenen Überwachungsschutzschaltung 7 im Testbetrieb, wobei ein spannungsbegrenzendes Bauteil 5 im Messpfad 3 ausgebildet und der Schalter S1 am Fußpunkt der Überwachungsschutzschaltung 7 angeordnet ist. Dabei wird die Spannung durch ein Bauteil 5, z.B. eine Zenerdiode derart begrenzt, dass über der Beleuchtungseinheit eine Prüfspannung Uₓ abfällt, die kleiner als die Flussspannung der Dioden-Anordnung ist. Anschließend wird beispielsweise über einen Shunt-Widerstand der Strom I_{L} im Lastpfad durch die Beleuchtungseinheit 1 ermittelt. Dieser Wert wird mit einem Wert I_{Soll} aus der Soll-Strom-Spannungskennlinie der Beleuchtungseinheit 1 verglichen (veranschaulicht als gestrichelte Linie in Fig.la und Fig. 1b). Tritt eine festzulegende Abweichung zwischen I_{L} und I_{Soll} auf, z.B. wenn ein Fehlerwiderstand R_{Fehler} in der Beleuchtungsanlage vorhanden ist (veranschaulicht als gestrichelte Linie in Fig.lb), so wird die Beleuchtungseinheit 1 unverzüglich ausgeschaltet. Anderenfalls wird die Beleuchtungseinheit 1 eingeschaltet bzw. bleibt weiter in Betrieb (veranschaulicht als gestrichelte Linie in Fig.1a).

Fig. 3a zeigt die schematische Darstellung der vorgeschlagenen Überwachungsschutzschaltung 7 im Testbetrieb, wobei ein strombegrenzendes Bauteil 5 im Messpfad 3 ausgebildet ist und der Schalter S1 an der Energieversorgung 2 der Überwachungsschutzschaltung 7 angeordnet ist. In Bezug auf die Kennlinie einer Diode (Fig. 1) wird der Strom durch ein Bauteil 5, z.B. einen Widerstand, auf einen bestimmten festgelegten Wert Iₓ (Prüfstrom) begrenzt. Anschließend wird über den Spannungsteiler, welcher aus der Beleuchtungseinheit 1 und dem Widerstand 5 gebildet wird, die Spannung U_{L} über der Beleuchtungseinheit 1 ermittelt. Dieser Wert wird mit einem Wert U_{Soll} aus der Soll-Strom-Spannungskennlinie der Beleuchtungseinheit 1 im Betriebsfall verglichen (veranschaulicht als Strich-Punkt-Linie in Fig.la und Fig.lb). Tritt eine festzulegende Abweichung zwischen U_{L} und U_{Soll} auf, z.B. wenn ein Fehlerwiderstand R_{Fehler} in der Beleuchtungsanlage vorhanden ist (veranschaulicht als Strich-Punkt-Linie in Fig. 1b), so wird die Beleuchtungseinheit 1 unverzüglich ausgeschaltet. Anderenfalls wird die Beleuchtungseinheit 1 eingeschaltet bzw. bleibt weiter in Betrieb (veranschaulicht als Strich-Punkt-Linie in Fig.1a).

Fig. 3b zeigt die schematische Darstellung der vorgeschlagenen Überwachungsschutzschaltung 7 im Testbetrieb, wobei ein spannungsbegrenzendes Bauteil 5 im Messpfad 3 ausgebildet und der Schalter S1 an der Energieversorgung 2 der Überwachungsschutzschaltung 7 angeordnet ist. Dabei wird die Spannung durch ein Bauteil 5, z.B. eine Zenerdiode derart begrenzt, dass über der Beleuchtungseinheit eine Prüfspannung Uₓ abfällt, die kleiner als die Flussspannung U_{F} der Dioden-Anordnung ist. Anschließend wird beispielsweise über einen Shunt-Widerstand der Strom I_{L} im Lastpfad durch die Beleuchtungseinheit 1 ermittelt. Dieser Wert wird mit einem Wert I_{Soll} aus der Soll-Strom-Spannungskennlinie der Beleuchtungseinheit 1 verglichen (veranschaulicht als gestrichelte Linie in Fig.la und Fig. 1b). Tritt eine festzulegende Abweichung zwischen I_{L} und I_{Soll} auf, z.B. wenn ein Fehlerwiderstand R_{Fehler} in der Beleuchtungsanlage vorhanden ist (veranschaulicht als gestrichelte Linie in Fig.lb), so wird die

Beleuchtungseinheit 1 unverzüglich ausgeschaltet. Anderenfalls wird die Beleuchtungseinheit 1 eingeschaltet bzw. bleibt weiter in Betrieb (veranschaulicht als gestrichelte Linie in Fig.1a).

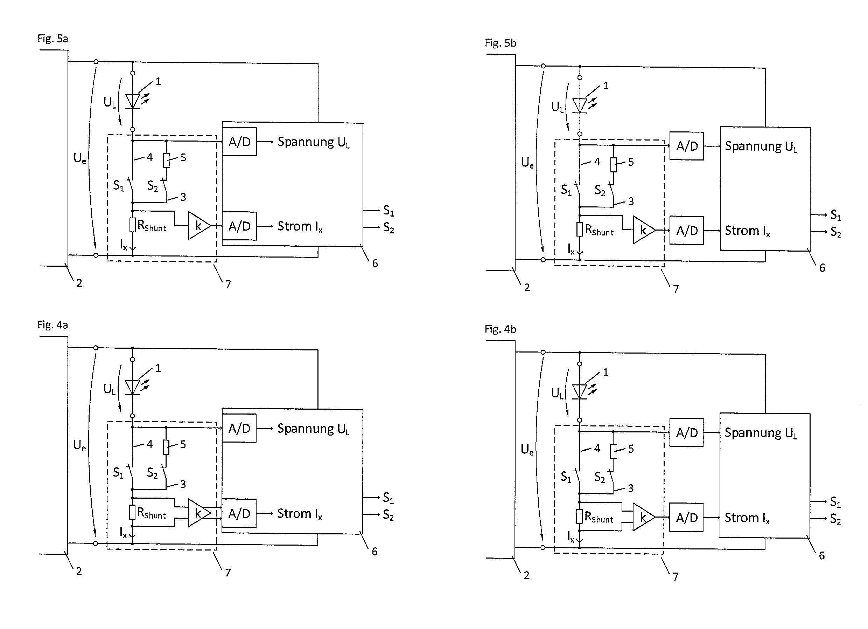

Fig. 4a zeigt die schematische Darstellung der vorgeschlagenen Überwachungsschutzschaltung 7 im Testbetrieb für Beleuchtungsanlagen an einem konkreten Ausführungsbeispiel der Fig. 3a, wobei die Beleuchtungseinheit als Verbraucher im Lastpfad 4 im Ausführungsbeispiel z.B. mindestens eine LED umfasst. Die LED besitzt eine nichtlineare Kennlinie, wobei bis zum Erreichen der Flussspannung (U_{F}) von z.B. 2,5 V der Stromfluss durch die LED nahezu Null ist und die LED erst bei einer von der Art der LED abhängigen bestimmten Flussspannung (im Beispiel also 2,5 V) leitend wird. Wird die Beleuchtungsanlage mit einem 12V-Netzteil 2 betrieben und werden beispielsweise drei in Reihe geschalteten LEDs und ein Lastwiderstand in Reihe geschaltet, verwendet, so fließt bis etwa 7,5 V nahezu kein Strom. Als Bauteil 5 im Messpfad 3 wird beispielsweise ein 10-kOhm-Widerstand eingesetzt. Gemäß den ohmschen Gesetzen fließen damit rund 450 pA durch den Messpfad 3, wobei dieser Strom kein nennenswertes Leuchten der LEDs verursacht. Tritt nun in der Beleuchtungsanlage ein Widerstand, z.B. ein Fehlerwiderstand R_{Fehler} von 1 kOhm auf, so wirkt dieser Fehlerwiderstand als ohmsche Last und sorgt damit auch bei geringen Spannungen von 1 V oder 2 V (also unter 7,5 V) für einen messbaren Stromfluss. Dadurch erkennt die Steuereinheit 6 dass ein Fehlerzustand vorliegt und verweigert das Einschalten der Beleuchtungseinheit 1. Für die Messung der Strom-Spannungswerte kann beispielsweise eine Vierpunktmessung verwendet werden, wobei unter Verwendung eines sehr niederohmigen Widerstandes, z.B. eines Shunt-Widerstandes, sehr genaue Strommessungen durchgeführt werden können. Die Verarbeitung der aufgenommenen Messsignale erfolgt in einer Steuereinheit 6, z.B. einem Mikrokontroller mit integriertem A/D-Wandler.

Fig. 4b zeigt die gleiche Überwachungsschutzschaltung im Testbetrieb wie in Fig. 4a mit dem Unterschied, dass zur Verarbeitung der aufgenommenen analogen Signale ein externer A/D-Wandler verwendet wird.

In einem weiteren Ausführungsbeispiel kann die Strommessung auch unipolar erfolgen (Fig. 5a und 5b). Die Verfahrensschritte erfolgen analog zum ersten Ausführungsbeispiel. Die detektierten analogen Signale können auch hier mit einem integrierten (Fig. 5a) oder einem separaten (Fig. 5b) A/D-Wandler erfolgen.

In einem weiteren Ausführungsbeispiel kann die vorgeschlagene Überwachungsschutzschaltung in vorteilhafter Weise in einen Dimmer eingebaut sein.

### Bezugszeichenliste

- 1: Beleuchtungseinheit
- 2: Energieversorgung
- 3: Messpfad
- 4: Lastpfad
- 5: Bauteil im Messpfad
- 6: Steuereinheit
- 7: Überwachungsschutzschaltung
- 8: charakteristische Strom-Spannungskennlinie einer Diode
- 81: Strom-Spannungskennlinie einer Diode mit Fehlerwiderstand
- 9: Fehlerwiderstand
- S1: Lastschalter
- S2: zweiter Schalter
- Uₓ: Prüf spannung
- Iₓ: Prüfstrom
- U_{F}: Flussspannung der Dioden-Anordnung

## Patentansprüche

1. Überwachungsschutzschaltung (7) für Beleuchtungsanlagen, welche eine Beleuchtungseinheit (1), eine Energieversorgung und eine elektrische Größen messende Messeinrichtung umfasst, **dadurch gekennzeichnet, dass** ein mit der Beleuchtungseinheit (1) verbundener Lastpfad (4) und ein Messpfad (3) ausgebildet sind, wobei in dem Lastpfad (4), ein die Beleuchtungseinheit (1) ein- und ausschaltender Lastschalter (S1) angeordnet ist und in dem Messpfad (3) eine die Spannung über dem Lastschalter (S1) und / oder den Strom in dem Messpfad messende Messeinrichtung angeordnet ist, wobei die Messeinrichtung ein Bauteil (5) umfasst, welches parallel zum Lastschalter (S1) angeordnet und als ein strombegrenzendes und / oder als ein spannungsbegrenzendes Bauteil ausgebildet ist und dieser Teil des Messpfades mit einer die gemessene Spannung und / oder den gemessenen Strom auswertenden Einheit (6) verbunden ist, die einen Steuerausgang aufweist, der mit dem Lastschalter (S1) diesen steuernd verbunden ist.

2. Überwachungsschutzschaltung nach Anspruch 1, **dadurch gekennzeichnet, dass** die Beleuchtungseinheit (1) mindestens eine Leuchtdiode umfasst.

3. Überwachungsschutzschaltung nach einem der vorherigen Ansprüche, **dadurch gekennzeichnet, dass** in Reihe zu dem Bauteil (5) im Messpfad (3) ein zweiter, alternativ zum Lastschalter schaltender Schalter (S2) angeordnet ist.

4. Überwachungsschutzschaltung nach einem der Ansprüche 1 bis 3, **dadurch gekennzeichnet, dass** das Bauteil (5) im Messpfad (3) derart ausgebildet ist, dass ein resultierender Prüfstrom Iₓ eine bis fünf Größenordnungen kleiner als der Nennstrom im Arbeitspunkt der Beleuchtungseinheit (1) ist.

5. Überwachungsschutzschaltung nach Anspruch 4, **dadurch gekennzeichnet, dass** das Bauteil (5) im Messpfad (3) ein Widerstand ist.

6. Überwachungsschutzschaltung nach einem der Ansprüche 1 bis 3, **dadurch gekennzeichnet, dass** das Bauteil (5) im Messpfad (3) derart ausgebildet ist, dass eine resultierende Prüfspannung Uₓ kleiner als die Flussspannung der Beleuchtungseinheit (1) ist.

7. Überwachungsschutzschaltung nach Anspruch 6, **dadurch gekennzeichnet, dass** das Bauteil (5) im Messpfad (3) eine Zenerdiode ist.

8. Überwachungsschutzschaltung nach einem der vorherigen Ansprüche, **dadurch gekennzeichnet, dass** die Schalter (S1, S2) elektronisch arbeitend ausgebildet sind.

9. Überwachungsschutzschaltung nach einem der vorherigen Ansprüche, **dadurch gekennzeichnet, dass** die Schalter (S1, S2) elektromagnetisch arbeitend ausgebildet sind.

10. Überwachungsschutzschaltung nach einem der vorherigen Ansprüche, **dadurch gekennzeichnet, dass** die auswertende Einheit (6) ein Mikrocontroller mit integriertem oder separatem Analog-Digital-Wandler ist.

11. Überwachungsschutzschaltung nach einem der vorherigen Ansprüche, **dadurch gekennzeichnet, dass** die Überwachungsschutzschaltung (7) mit diskreter Logik oder in einem ASIC (Anwendungsspezifische Integrierte Schaltung) ausgebildet ist.

12. Verfahren zur Überwachung von einer Beleuchtungsanlage, welche eine Beleuchtungseinheit (1), eine Energieversorgung (2) und eine elektrische Größen messende Messeinrichtung umfasst, **dadurch gekennzeichnet, dass** mit der Überwachungsschutzschaltung (7), welche einen die Beleuchtungseinheit (1) ein- und ausschaltenden Lastschalter (S1) und ein strombegrenzendes und / oder spannungsbegrenzendes Bauteil (5) im Messpfad (3) umfasst, folgende Schritte ausgeführt werden:
- die Energieversorgung (2) der Beleuchtungseinheit (1) wird über den Lastschalter (S1) unterbrochen,
- mit der Messeinrichtung wird über einen aus Beleuchtungseinheit (1) und dem Bauteil (5) im Messpfad (3) gebildeten Spannungsteiler die Spannung U_{L} über der Beleuchtungseinheit (1) ermittelt, oder mit der Messeinrichtung wird mit dem spannungsbegrenzenden Bauteil (5) im Messpfad (3) der Strom I_{L} durch die Beleuchtungseinheit (1) ermittelt,
- die ermittelte Spannung U_{L} oder der ermittelte Strom I_{L} wird mit einer bekannten Soll-Strom-Spannungskennlinie der Beleuchtungseinheit (1) verglichen,
- bei Übereinstimmung der ermittelten Spannung U_{L} mit der erwarteten Spannung U_{Soll} aus der Soll-Strom-Spannungskennlinie der Beleuchtungseinheit (1) wird die Beleuchtungseinheit (1) eingeschaltet und bei einer festzulegenden Abweichung der Spannung U_{L} von der erwarteten Spannung U_{Soll} aus der Soll-Strom-Spannungskennlinie der Beleuchtungseinheit (1) wird die Beleuchtungseinheit (1) unverzüglich ausgeschaltet oder bei Übereinstimmung des ermittelten Stroms I_{L} mit dem erwarteten Strom I_{Soll} aus der Soll-Strom-Spannungskennlinie der Beleuchtungseinheit (1) wird die Beleuchtungseinheit (1) eingeschaltet und bei einer festzulegenden Abweichung des Stroms I_{L} von dem erwarteten Strom I_{Soll} aus der Soll-Strom-Spannungskennlinie der Beleuchtungseinheit (1) wird die Beleuchtungseinheit unverzüglich ausgeschaltet.

13. Verfahren nach einem der vorherigen Ansprüche, **dadurch gekennzeichnet, dass** das Verfahren während des Betriebs der Beleuchtungsanlage durchgeführt wird.

14. Verfahren nach einem der vorherigen Ansprüche, **dadurch gekennzeichnet, dass** die Schritte des Verfahrens zeitlich periodisch wiederholt werden.

15. Verfahren nach einem der vorherigen Ansprüche, **dadurch gekennzeichnet, dass** mit einem zweiten alternativ zum Lastschalter (S1) schaltenden Schalter (S2) die Beleuchtungseinheit (1) bei einer festzulegenden Abweichung der Spannung U_{L} von der erwarteten Spannung U_{Soll} aus der Soll-Strom-Spannungskennlinie der Beleuchtungseinheit (1) oder bei einer festzulegenden Abweichung des Stromes I_{L} von dem erwarteten Strom I_{Soll} aus der Soll-Strom-Spannungskennlinie der Beleuchtungseinheit (1) vollständig von der Energieversorgung (2) getrennt wird.
